(19) Europäisches Patentamt / European Patent Office / Office européen des brevets

(11) **EP 3 798 649 B1**

(12) **FASCICULE DE BREVET EUROPEEN**

(45) Date de publication et mention de la délivrance du brevet:
**10.04.2024 Bulletin 2024/15**

(21) Numéro de dépôt: **20306090.0**

(22) Date de dépôt: **25.09.2020**

(51) Classification Internationale des Brevets (IPC):
**G01R 31/08** $^{(2020.01)}$ **G01R 31/11** $^{(2006.01)}$

(52) Classification Coopérative des Brevets (CPC):
**G01R 31/11; G01R 31/085; G01R 31/088;**
G01R 31/086; Y04S 10/52

(54) **PROCÉDÉ DE DÉTERMINATION D'UNE POSITION D'UN SITE DE DÉCHARGE PARTIELLE DANS UN CÂBLE HAUTE TENSION EN FONCTIONNEMENT**

VERFAHREN ZUR BESTIMMUNG DER POSITION EINER TEILENTLADUNGSSTELLE IN EINEM IN BETRIEB BEFINDLICHEN HOCHSPANNUNGSKABEL

METHOD FOR DETERMINING THE POSITION OF A PARTIAL DISCHARGE SITE IN A HIGH-VOLTAGE CABLE IN OPERATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2019 FR 1910640**

(43) Date de publication de la demande:
**31.03.2021 Bulletin 2021/13**

(73) Titulaire: **Electricité de France**
**75008 Paris (FR)**

(72) Inventeurs:
• **DIGARD, Hervé**
**77940 LA BROSSE-MONTCEAUX (FR)**
• **ESPILIT, Thierry**
**77250 MORET SUR LOING (FR)**
• **DUBOSCQ, Sylvain**
**77250 VENEUX LES SABLONS (FR)**

(74) Mandataire: **Regimbeau**
**20, rue de Chazelles**
**75847 Paris Cedex 17 (FR)**

(56) Documents cités:
FR-A1- 3 003 410    FR-A1- 3 050 036
FR-A1- 3 050 036    GB-A- 2 496 121
US-A- 5 682 100

• **Peter C J M Van ET AL: "ON-LINE PARTIAL DISCHARGE DETECTION OF MV CABLES WITH DEFECT LOCALISATION (PDOL) BASED ON TWO TIME SYNCHRONISED SENSORS", , 6 juin 2005 (2005-06-06), pages 1-5, XP055123588, Turin Extrait de l'Internet: URL:http://www.cired.net/publications/cired2005/papers/cired2005_0456.pdf [extrait le 2014-06-16]**

EP 3 798 649 B1

## Description

## DOMAINE DE L'INVENTION

La présente invention concerne le domaine général de la localisation de sites de décharge partielle dans un câble haute tension en fonctionnement.

## ETAT DE LA TECHNIQUE

Les câbles haute tension, typiquement les câbles Haute Tension A (« HTA »), font partie du système de distribution électrique et transmettent un signal Haute Tension triphasé. Le signal haute tension est périodique (typiquement d'une période de 20 millisecondes pour une fréquence de 50Hz) et d'amplitude élevée (typiquement 20 kVolts).

Dans les câbles haute tension, différents types de défaillances dans la conduction électrique peuvent apparaître au cours du temps.

Un premier type de défaillances possible est l'apparition d'un site de décharge partielle qui est un défaut localisé dans l'isolation du câble. Ce site produit une décharge électrique de très faible amplitude qui n'impacte qu'une faible portion de l'isolation. La décharge partielle se produit lorsque le signal haute tension dépasse une tension dite d'apparition, et s'éteint lorsque la tension redescend sous cette tension d'apparition et qualifiée alors de tension d'extinction. Les décharges partielles peuvent se répéter plusieurs fois par période.

Un deuxième type de défaillance possible est l'apparition d'un précurseur de défaut, appelé aussi « pré-défaut » ou « défaut auto-extincteur ». Ce deuxième type de défaillance est plus grave que l'apparition d'un site de décharge partielle : en effet, lorsque le signal haute tension atteint un certain seuil, généralement au maximum de la tension du réseau, le précurseur de défaut peut générer une décharge totale. Il y a alors une chute brutale de la tension dans le câble à zéro et circulation d'un courant d'amplitude significative dans le défaut. Dans le cas du défaut auto-extincteur, la perturbation s'achève avant la demi-période suivante, et le signal haute tension suit à nouveau la courbe attendue. Cette décharge totale ne se produit pas nécessairement à chaque demi-période du signal haute tension.

Enfin, un troisième type de défaillance est l'apparition d'un défaut franc. Ce troisième type de défaillance est plus grave que les deux précédents. Lorsque le signal haute tension atteint un certain seuil, le défaut franc produit une décharge totale. Il y a alors une chute brutale de la tension dans le câble à zéro. La perturbation dure plusieurs demi-périodes successives sans interruption. La perturbation conduit dans ce cas à l'ouverture du disjoncteur de protection sur la liaison haute tension pour mettre un terme à la perturbation.

Si aucune intervention n'est menée sur le câble, un site de décharge partielle peut, au bout d'un certain temps, devenir un précurseur de défaut puis finalement devenir un défaut franc.

Il est important de surveiller les câbles haute tension afin d'en estimer l'état de santé et d'intervenir avant l'apparition du défaut franc.

Il existe des procédés de détection et de localisation de défaillance dans la conduction électrique du câble haute tension. Certains procédés de détection (qualifiés de procédé « on-line ») sont mis en oeuvre alors que le câble haute tension est « en fonctionnement ». Un câble haute tension est « en fonctionnement » lorsqu'il est connecté au reste du réseau de distribution et qu'il est alimenté par le signal haute tension du réseau de distribution.

D'autres procédés de détection (qualifiés de procédé « off-line ») requièrent que le câble haute tension soit « hors fonctionnement », c'est-à-dire qu'il soit isolé du reste du réseau de distribution. L'intervention d'une équipe de techniciens est alors nécessaire sur site pour réaliser une déconnexion du câble et mener les tests avec une alimentation électrique dédiée.

FR 3 003 410 A1 décrit un dispositif de protection de réseaux électriques, le dispositif étant configuré pour envoyer un signal et déclencher l'ouverture d'un interrupteur lorsqu'une modification d'impédance dépasse un seuil donné caractérisant un défaut.

Pour surveiller les câbles haute tension et estimer leur état de santé, les procédés de détection et de localisation de défaillance du câble haute tension « on-line » présentent l'avantage de ne pas mobiliser une équipe de techniciens, de ne pas être limités temporellement à la durée de l'intervention de l'équipe et de poursuivre la distribution électrique en utilisant tous les câbles haute tension du système de distribution électrique.

Parmi les procédés « on-line » de détection et de localisation d'un site de décharge partielle dans un câble haute tension, on connaît des procédés qui consistent à mettre en oeuvre deux points de mesure de part et d'autre de la liaison à surveiller.

Par exemple un tel procédé de détection et de localisation d'un site de décharge partielle peut suivre la chronologie suivante : une décharge partielle se produit dans le câble et deux impulsions électriques sont générées à partir du site de décharge partielle et se propagent en sens inverses. Chaque impulsion électrique se propage vers un des deux points de mesure. En chaque point de mesure une impulsion est détectée et horodatée. Connaissant la longueur de câble haute tension séparant les deux points de mesure, la vitesse de propagation et les instants de détection des deux impulsions, il est possible de déterminer la position du site de décharge partielle. Une synchronisation temporelle des horloges situées aux deux points de mesure avec une précision de l'ordre de la dizaine de nanosecondes est nécessaire pour mettre en oeuvre le procédé et localiser finement le site de décharge partielle. Cette synchronisation peut être obtenue à partir d'un système GPS.

Un tel procédé présente différents inconvénients. Tout d'abord il est nécessaire d'utiliser un système de synchronisation de très haute stabilité et donc couteux à l'achat. Par ailleurs, il existe des difficultés de captation d'un signal GPS en milieu urbain ce qui rend l'application du procédé plus difficile en ville. Enfin, un autre désavantage est que le traitement des informations est lié à un abonnement auprès du fournisseur ce qui entraîne un surcout d'abonnement lié au nombre de liaisons à surveiller, et le fait que le fournisseur a accès aux données de l'opérateur de réseau.

Il existe donc un besoin pour un procédé de détection et de localisation de site de décharge partielle dans un câble haute tension en fonctionnement qui est plus simple à mettre en oeuvre, d'une part parce qu'il ne nécessite pas d'utiliser un système de synchronisation et d'autre part parce qu'il peut être mené localement sur site, permettant à l'opérateur de réseau d'être autonome dans l'exploitation des résultats.

**EXPOSE DE L'INVENTION**

Un but général de l'invention est de proposer un procédé de détection et de localisation de site de décharge partielle dans un câble haute tension en fonctionnement qui est plus simple à mettre en oeuvre que dans l'art antérieur.

Le but est atteint dans le cadre de la présente invention grâce à un procédé de détermination d'une position d'un site de Décharge Partielle au sein d'une phase détériorée d'une ligne haute tension en fonctionnement, la ligne haute tension étant formée d'une pluralité de câbles haute tension reliant une pluralité de postes HTA/BT entre eux, comprenant les étapes suivantes :

acquisition par un premier poste HTA/BT d'une mesure d'une première signature dans le signal haute tension se propageant dans la phase détériorée, la première signature comportant des impulsions électriques dues à une propagation et des réflexions au sein de la phase détériorée d'une perturbation électrique générée par le site de Décharge Partielle,

comparaison de la mesure de la première signature à une première signature de référence de la phase détériorée, la première signature de référence ayant été déterminée au préalable au cours d'une calibration par réflectométrie d'un signal de référence injecté au sein du premier poste HTA/BT,

identification, lorsque la mesure de la première signature est superposée avec la première signature de référence de sorte qu'une impulsion initiale de la mesure de la première signature et une impulsion initiale de la première signature de référence coïncident, d'une première impulsion non-coïncidente dans la mesure de la première signature qui ne coïncide avec aucune impulsion de la première signature de référence, et d'une première impulsion de référence non-coïncidente dans la première signature de référence qui ne coïncide avec aucune impulsion de la mesure de la première signature,

détermination de la position du site de Décharge Partielle en fonction de la durée qui sépare l'impulsion initiale et la première impulsion non-coïncidente dans la mesure de la première signature.

Grâce à l'utilisation d'une signature comportant des impulsions électriques dues à une propagation et des réflexions au sein de la phase détériorée d'une perturbation électrique générée par le site de Décharge Partielle, et d'une signature de référence déterminée par réflectométrie d'un signal de référence, l'ensemble des mesures peut être réalisé en un seul endroit. Le procédé proposé ne nécessite donc pas d'utiliser un système pour assurer la synchronisation de deux appareils séparés géographiquement.

De plus, la comparaison des signatures permet de localiser de manière simple le site de décharge partielle, sans qu'il soit nécessaire de transmettre les données de mesure vers un dispositif de traitement distant. Ainsi, l'opérateur de réseau peut être autonome dans l'exploitation des résultats

Un tel procédé est avantageusement complété par les différentes caractéristiques ou étapes suivantes prises seules ou en combinaison :

la première signature comporte des impulsions électriques dues à des réflexions de la perturbation électrique créées au niveau d'au moins deux postes HTA/BT voisins du premier poste HTA/BT ;

différents câbles haute tension sont tous reliés directement au premier poste HTA/BT, chaque câble haute tension comprenant au moins une phase, chaque phase étant alimentée par un signal haute tension respectif, l'étape d'acquisition par un premier poste HTA/BT d'une mesure d'une première signature comprenant une détermination de la phase détériorée selon les sous étapes suivantes :

acquisition par le premier poste HTA/BT de mesures de premières signatures dans les différents signaux alimentant les phases des différents câbles haute tension,

identification de la phase détériorée pour laquelle la première signature présente les mesures de plus fortes amplitudes ;

une étape de détermination de l'énergie, l'amplitude, la fréquence d'apparition et/ou de la valeur du signal haute tension des mesures de la première signature du site de Décharge Partielle ;

les étapes suivantes :

acquisition par un deuxième poste HTA/BT d'une mesure d'une deuxième signature dans le signal haute tension se propageant dans la phase détériorée, la mesure de la deuxième signature comportant des impulsions électriques dues à une propagation et des réflexions au sein de la phase détériorée d'une perturbation électrique générée par le site de Décharge Partielle, comparaison de la mesure de la deuxième signature à une deuxième signature de référence de la phase détériorée, la deuxième signature de référence ayant été déterminée au préalable au cours d'une calibration par réflectométrie d'un signal de référence injecté au sein du deuxième poste HTA/BT, identification, lorsque la mesure de la deuxième signature est superposée avec la deuxième signature de référence de sorte qu'une impulsion initiale de la mesure de la deuxième signature et une impulsion initiale de la deuxième signature de référence coïncident, d'une deuxième impulsion non-coïncidente dans la mesure de la deuxième signature qui ne coïncide avec aucune impulsion de la deuxième signature de référence, et d'une deuxième impulsion de référence non-coïncidente dans la deuxième signature de référence qui ne coïncide avec aucune impulsion de la mesure de la deuxième signature, l'étape de détermination de la position du site de Décharge Partielle étant réalisée aussi en fonction d'une durée qui sépare l'impulsion initiale et la deuxième impulsion non-coïncidente dans la mesure de la deuxième signature ;

l'étape d'acquisition par un premier poste HTA/BT d'une mesure d'une première signature comprend en outre la détection d'une valeur du signal haute tension à chaque instant d'acquisition d'une mesure de la première signature ;

pour chaque phase reliée au premier poste HTA/BT, une série de couples de mesures simultanées est réalisée, un couple de mesures simultanées comprenant une mesure à un instant de mesure d'une signature de référence de la phase par le poste HTA/BT et une mesure à l'instant de mesure d'une valeur du signal haute tension qui alimente la phase, une détection d'une variation d'amplitude de la signature de référence en fonction de la valeur du signal haute tension et en fonction de l'instant, la variation d'amplitude étant représentative d'un changement d'impédance de la phase, un signal d'alerte est généré si la variation d'amplitude détectée est supérieure à un seuil prédéterminé ;

L'invention porte également sur un dispositif de détermination d'une position d'un site de Décharge Partielle au sein d'une phase détériorée d'une ligne haute tension en fonctionnement, la ligne haute tension étant formée d'une pluralité de câbles haute tension reliant une pluralité de postes HTA/BT entre eux, comprenant un système d'acquisition de signaux électriques adapté pour acquérir une mesure sur la phase détériorée d'une première signature d'un site de Décharge Partielle, une unité de traitement adaptée pour comparer la mesure de la première signature à une première signature de référence de la phase détériorée, la première signature de référence ayant été déterminée au préalable au cours d'une calibration par réflectométrie d'un signal de référence injecté au sein d'un poste HTA/BT, détecter une impulsion électrique additionnelle dans la mesure de la première signature par rapport à la première signature de référence, déterminer la position du site de Décharge Partielle en fonction d'une position de l'impulsion électrique additionnelle détectée par rapport aux autres impulsions contenues dans la mesure de la première signature.

Avantageusement, mais facultativement, le dispositif peut être complété par les différentes caractéristiques ou étapes suivantes prises seules ou en combinaison :

un injecteur adapté pour envoyer sur la phase détériorée un signal de référence ;

la première signature comporte des impulsions électriques dues à des réflexions de la perturbation électrique créées au niveau d'au moins deux postes HTA/BT voisins d'un premier poste HTA/BT ;

le système d'acquisition de signaux électriques est adapté pour acquérir sur des phases de différents câbles haute tension reliés directement à un poste HTA/BT des mesures d'une première signature d'un site de Décharge Partielle, et l'unité de traitement est adaptée en outre pour identifier la phase détériorée pour laquelle la première signature présente les mesures de plus fortes amplitudes ;

le système d'acquisition et l'unité de traitement sont adaptés pour déterminer l'énergie, l'amplitude, la fréquence et/ou de la valeur du signal haute tension d'apparition des mesures de la première signature du site de Décharge Partielle.

Enfin, l'invention porte sur un ensemble de deux dispositifs de détection tels qu'on vient de les décrire, les dispositifs étant localisés dans deux postes HTA/BT différents.

## DESCRIPTION DES FIGURES

D'autres caractéristiques et avantages de l'invention ressortiront encore de la description qui suit, laquelle est purement illustrative et non limitative, et doit être lue en regard des dessins annexés sur lesquels :

La figure 1 représente schématiquement une structure d'une partie d'un réseau de distribution électrique comprenant plusieurs postes HTA/BT reliés par un câble haute tension.

La figure 2 représente schématiquement un procédé de détection et de localisation d'un site de décharge partielle conforme à un mode de réalisation de l'invention.

La figure 3 représente schématiquement une signature de référence d'une phase du câble haute tension.

Les figures 4A et 5A représentent schématiquement une détection de décharge partielle par réflectométrie.

Les figures 4B et 5b représentent schématiquement une signature d'un site de décharge partielle dans une phase du câble haute tension.

## DESCRIPTION DETAILLEE DE L'INVENTION

*Dispositif de localisation d'un site de décharge partielle*

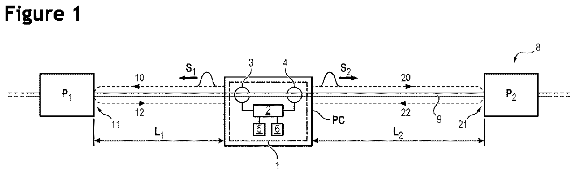

La figure 1 représente une structure d'une partie 8 d'un réseau de distribution électrique comprenant plusieurs postes Haute Tension A / Basse Tension (« HTA/BT ») PC, P1 et P2 reliés par un câble haute tension 9. Les postes sont reliés en série par le câble haute tension 9, le poste HTA/BT central PC est entouré de deux postes HTA/BT voisins P1 et P2.

La longueur de la portion de câble haute tension entre le poste HTA/BT central PC et le premier poste HTA/BT voisin P1 est notée L1.

La longueur de la portion de câble haute tension entre le poste HTA/BT central PC et le deuxième poste HTA/BT voisin P2 est notée L2.

Dans la pratique, ces deux longueurs sont différentes. Il a été choisi dans l'exemple illustré sur la figure 1 de présenter la situation où la longueur L2 est supérieure à la longueur L1.

En amont de la mise en oeuvre du procédé de détection, les longueurs L1 et L2 peuvent être déterminées. Ces longueurs valent classiquement entre 300 et 1000 mètres.

Chaque poste HTA/BT comprend un transformateur HTA/BT connecté au câble haute tension 9 via un interrupteur. Un tel transformateur comprend un primaire alimenté par le triphasé du câble haute tension, et un secondaire qui distribue l'énergie vers les abonnés.

Le câble haute tension 9 est formé de trois phases haute tension non représentées sur la figure 1 et est alimenté par un signal haute tension triphasé.

La câble haute tension 9 est un câble souterrain.

Les phases haute tension unipolaires des réseaux de distribution présentent chacune une structure coaxiale constituée de trois parties : une âme conductrice, un isolant diélectrique qui entoure l'âme conductrice et un écran métallique qui entoure l'isolant.

L'isolant diélectrique est soit de nature synthétique, comme par exemple le polyéthylène, soit à base de papier imprégné pour les technologies les plus anciennes.

La structure coaxiale des câbles est assimilable à une ligne de transmission et les phénomènes transitoires qui affectent la liaison comme par exemple les défaillances dans la conduction électrique (décharges partielles, précurseurs de défaut) génèrent des ondes électromagnétiques qui se propagent dans les câbles.

La vitesse de propagation des phénomènes transitoires dépend de la nature du diélectrique. Pour les câbles usuellement utilisés, la vitesse de propagation des ondes varie entre 150 et 180 m/$\mu$s.

En amont de la mise en oeuvre du procédé de détection, la vitesse de propagation Vp des phénomènes transitoires dans le câble haute tension 9 est déterminée.

Le poste HTA/BT central PC comprend un dispositif de détermination 1 d'une position d'un site de Décharge Partielle.

Le dispositif de détermination 1 comprend un système d'acquisition 3 de signaux électriques adapté pour acquérir une mesure sur au moins une phase du câble haute tension 9 de phénomènes transitoires, en tension ou en intensité.

Le système d'acquisition 3 peut être composé d'au moins un détecteur d'impulsion électromagnétique, comme un tore de courant ou un capteur de courant à haute fréquence. Le système d'acquisition 3 est adapté pour reconnaître des phénomènes transitoires comme par exemple des anomalies de courant dues à un site de décharge partielle ou bien des impulsions électriques se propageant dans le câble haute tension 9.

Le système d'acquisition 3 comprend suffisamment de détecteurs pour mesurer les phénomènes transitoires sur chacune des phases du câble haute tension 9.

Le système d'acquisition comprend au moins un détecteur sur chacune des phases du câble haute tension 9. Eventuellement, le système d'acquisition peut comprendre deux détecteurs sur chacune des phases du câble haute tension 9, les deux détecteurs étant placés l'un du côté du premier poste HTA/BT voisin P1 et l'autre du côté du deuxième poste HTA/BT voisin P2.

Le dispositif de détermination 1 comprend également un injecteur 4 adapté pour envoyer un signal de référence sur n'importe quelle phase du câble haute tension 9. Le dispositif de détermination comprend au moins un injecteur sur chacune des phases du câble haute tension 9. Eventuellement, le système d'acquisition peut comprendre deux injecteurs sur chacune des phases du câble haute tension 9, les deux injecteurs étant placés l'un du côté du premier poste HTA/BT voisin P1 et l'autre du côté du deuxième poste HTA/BT voisin P2.

Le dispositif de détermination 1 comprend également une horloge 5 reliée au système d'acquisition 3 et à l'injecteur 4 de façon à dater des instants de détection d'une impulsion électrique ou des instants d'émission d'un signal de référence.

Le dispositif de détermination 1 comprend une unité de traitement 2 comprenant par exemple un processeur. L'unité de traitement 2 est adaptée pour comparer temporellement des évènements datés et effectuer des opérations mathématiques de base. L'unité de traitement est reliée à l'horloge 5 et à l'injecteur 4 de façon à pouvoir déclencher à un instant précis l'émission par l'injecteur 4 d'un signal de référence.

Le dispositif de détermination 1 comprend une mémoire 6 reliée à l'unité de traitement 2. La mémoire 6 peut notamment enregistrer des séquences temporelles d'acquisition réalisées par le système d'acquisition 3.

Le dispositif de détermination 1 est adapté, lors de la détection d'un phénomène transitoire comme une décharge partielle, pour déterminer l'énergie et l'amplitude des signaux électriques qui représentent le phénomène transitoire ainsi que la valeur du signal haute tension dans la phase du câble haute tension où le phénomène transitoire est détecté. Le dispositif de détermination 1 comprend au moins un capteur du signal haute tension sur une des phases du câble haute tension 9. A partir de la mesure de ce capteur, la valeur du signal haute tension sur les deux autres phases peut être déduite théoriquement. Eventuellement, le dispositif de détermination 1 peut comprendre un capteur du signal haute tension sur chacune des phases du câble haute tension 9.

Le dispositif de détermination 1 comprend une voie d'acquisition de transitoires rapides spécifique pour d'autres défauts que les sites de décharge partielle. Cette voie d'acquisition est synchrone avec les autres détecteurs et capteurs du dispositif de détermination. Cette voie d'acquisition peut comprendre un tore de courant type tore de Rogowski.

*Génération d'une signature de référence*

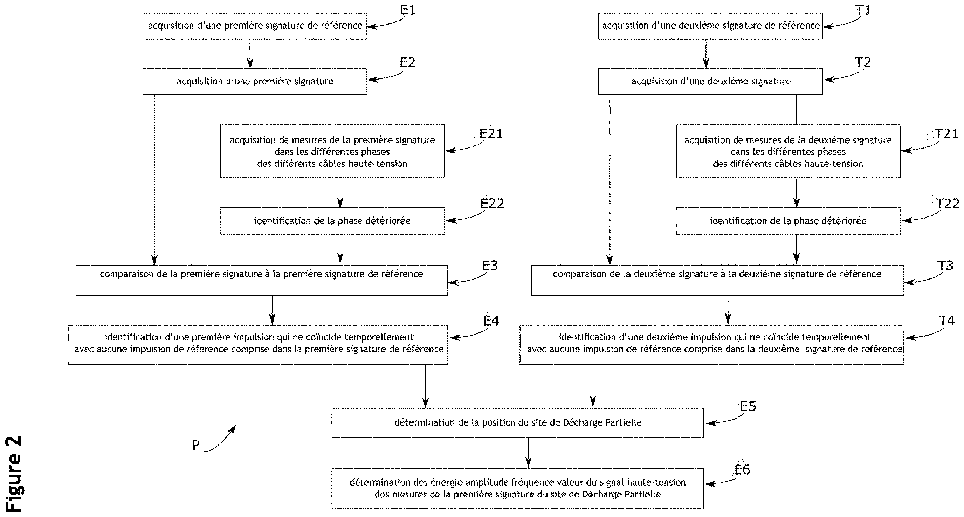

Le procédé de détermination d'une position d'un précurseur de défaut dans un câble haute tension détérioré comprend les étapes suivantes illustrées sur la figure 2.

Au cours d'une première étape E1, une signature de référence de la partie du câble haute tension 9 qui entoure le poste HTA/BT central PC est générée et mesurée par le dispositif de détermination 1.

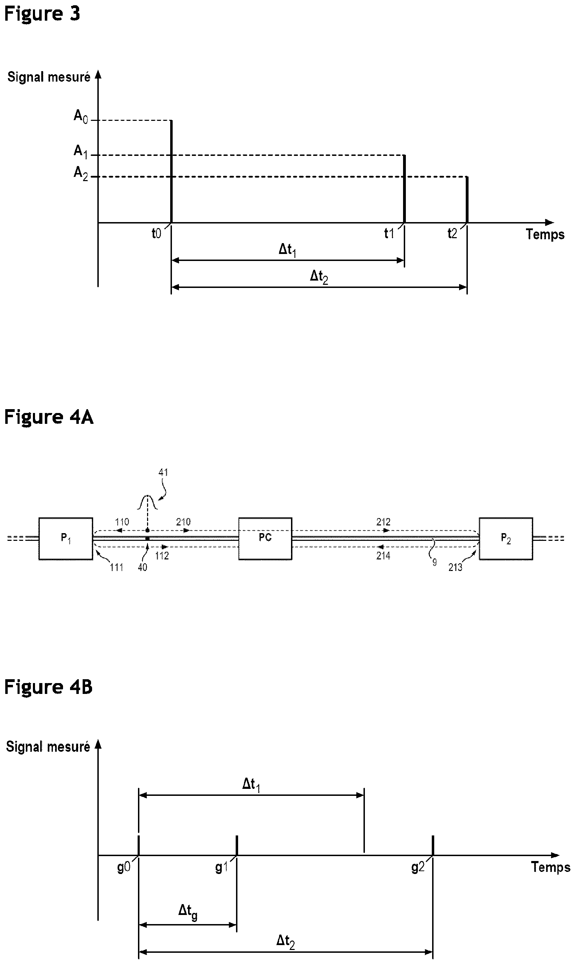

La première étape E1 du procédé est illustrée sur les figures 1 et 3.

L'injecteur 4 est contrôlé par l'unité de traitement 2 pour générer un signal de référence dans le câble haute tension 9.

Le signal de référence est mesuré par le système d'acquisition 3 à l'instant t0.

La mesure de cette excitation est représentée sur la figure 3 au temps t0.

L'excitation électrique produit deux impulsions de référence S1 et S2 qui se propagent à partir de l'injecteur 4 dans le câble haute tension 9.

La première impulsion de référence S1 se propage dans la direction de la flèche 10 vers le premier poste HTA/BT voisin P1.

Après avoir parcouru une longueur L1, la première impulsion S1 est réfléchie en partie au niveau 11 du premier poste HTA/BT voisin P1. Il y a en effet une rupture d'impédance dans le câble haute tension au niveau des postes HTA/BT qui occasionne une réflexion partielle des signaux électriques.

Une première impulsion retour qui est la partie réfléchie de la première impulsion de référence S1 se propage dans la direction de la flèche 12.

La première impulsion retour parcourt une longueur L1, avant de parvenir au poste HTA/BT central PC.

Toujours au cours de la première étape E1, la première impulsion retour est mesurée par le système d'acquisition 3 à l'instant t1.

La deuxième impulsion de référence S2 se propage quant à elle dans la direction de la flèche 20 vers le deuxième poste HTA/BT voisin P2.

Après avoir parcouru une longueur L2, la deuxième impulsion de référence S2 est réfléchie en partie au niveau 21 du deuxième poste HTA/BT voisin P2, pour la même raison qu'évoquée précédemment.

Une deuxième impulsion retour qui est la partie réfléchie de la deuxième impulsion de référence S2 se propage dans la direction de la flèche 22.

La deuxième impulsion retour parcourt une longueur L2, avant de parvenir au poste HTA/BT central PC.

Toujours au cours de la première étape E1, la deuxième impulsion retour est mesurée par le système d'acquisition 3 à l'instant t2.

La figure 3 représente la mesure obtenue par le système d'acquisition 3. Cette mesure forme une signature de référence.

La signature de référence peut être enregistrée dans la mémoire 6.

Le système d'acquisition 3 peut acquérir une signature de référence pour chacune des trois phases qui forment le câble haute tension. Les trois signatures de référence peuvent être enregistrées dans la mémoire 6.

Une telle signature de référence donne plusieurs informations sur la liaison électrique entre le poste HTA/BT central PC et les deux postes HTA/BT voisins P1 et P2. En particulier, une telle signature de référence comporte les informations présentées ci-après. La durée Δt1 est la durée d'un aller retour d'un signal électrique entre le poste HTA/BT central PC et le premier poste HTA/BT voisin P1.

La durée Δt2 est la durée d'un aller retour d'un signal électrique entre le poste HTA/BT central PC et le deuxième poste HTA/BT voisin P2.

Le rapport entre l'amplitude A1 de la première impulsion retour et de l'amplitude A0 du signal de référence dépend de la rupture d'impédance au premier poste HTA/BT voisin P1 et de l'atténuation sur un aller retour entre le poste HTA/BT central PC et le premier poste HTA/BT voisin P1.

Le rapport entre l'amplitude A2 de la deuxième impulsion retour et de l'amplitude A0 du signal de référence dépend de la rupture d'impédance au deuxième poste HTA/BT voisin P2 et de l'atténuation sur un aller retour entre le poste HTA/BT central PC et le deuxième poste HTA/BT voisin P2.

La mesure de la signature de référence telle que présentée plus haut est obtenue par réflectométrie d'un signal de référence injecté au sein du premier poste HTA/BT voisin et la première étape E1 peut être qualifiée d'étape de calibration.

*Mesure d'une signature d'une perturbation due à un site de décharge partielle*

Un site de décharge partielle 30 ou 40 est présent sur une des phases haute tension du câble haute tension 9.

Le site de décharge partielle 40 peut se situer entre le poste HTA/BT central PC et le premier poste HTA/BT voisin P1 comme dans le cas de la figure 4A.

A un instant où la tension dans la phase haute tension comportant le site de décharge partielle 40 dépasse en valeur absolue un certain seuil, une décharge partielle se produit. Cela crée une perturbation électrique 41 dans le signal haute tension passant dans le câble haute tension 9.

La perturbation électrique génère deux impulsions de perturbation qui se propagent dans le câble haute tension 9 :

- une première impulsion de perturbation qui se propage depuis le site de décharge partielle 40 vers le poste HTA/BT central PC selon la direction 210, et
- une deuxième impulsion de perturbation qui se propage depuis le précurseur de défaut 40 vers le premier poste HTA/BT voisin P1 selon la direction 110.

Après avoir parcouru une longueur inférieure à L1, la première impulsion de perturbation atteint le poste HTA/BT central PC.

Au cours d'une deuxième étape E2, le système d'acquisition 3 mesure la première impulsion de perturbation à un instant de détection g0.

Le système d'acquisition 3 peut également à cet instant de détection g0 mesurer la valeur instantanée de la tension du signal haute tension.

La première impulsion de perturbation poursuit sa propagation et traverse le poste HTA/BT central PC dans la direction de la flèche 212 vers le deuxième poste HTA/BT voisin P2.

Après avoir parcouru la longueur L2, la première impulsion de perturbation est réfléchie en partie au niveau 213 du deuxième poste HTA/BT voisin P2.

Une première impulsion réfléchie qui est la partie réfléchie de la première impulsion de perturbation se propage dans la direction de la flèche 214.

La première impulsion réfléchie parcourt une longueur L2, avant de parvenir au poste HTA/BT central PC.

Toujours au cours de la deuxième étape E2, la première impulsion réfléchie est mesurée par le système d'acquisition 3 à l'instant g2.

Le système d'acquisition 3 peut également à cet instant détection g2 mesurer la valeur instantanée de la tension du signal haute tension.

La deuxième impulsion de perturbation se propage quant à elle dans la direction de la flèche 110 vers le premier poste voisin HTA/BT P1.

Après avoir parcouru une longueur inférieure à la longueur L1, la deuxième impulsion de perturbation est réfléchie en partie au niveau 111 du premier poste HTA/BT voisin P1. Une deuxième impulsion réfléchie qui est la partie réfléchie de la deuxième impulsion de perturbation se propage dans la direction de la flèche 112.

La deuxième impulsion réfléchie parcourt une longueur L1, avant de parvenir au poste HTA/BT central PC.

Toujours au cours de la deuxième étape E2, la deuxième impulsion réfléchie est mesurée par le système d'acquisition 3 à l'instant g1.

Le système d'acquisition 3 peut également à cet instant détection g1 mesurer la valeur instantanée de la tension du signal haute tension.

La figure 4B représente la mesure obtenue par le système d'acquisition 3 et les instants de détection g0, g1 et g2. Compte-tenu du choix selon lequel la longueur L2 est supérieure à la longueur L1 et la position du site de décharge partielle 40 comprise entre le poste HTA/BT central PC et le premier poste HTA/BT voisin P1, l'instant g1 est antérieur à l'instant g2.

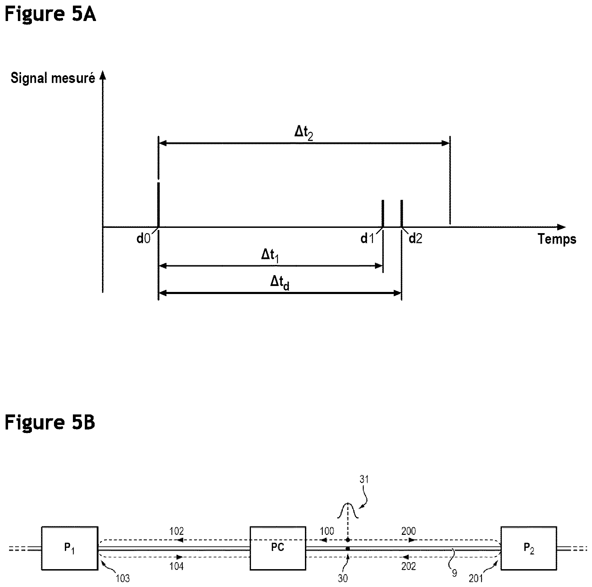

Le site de décharge partielle 30 peut aussi se situer entre le poste HTA/BT central PC et le deuxième poste HTA/BT voisin P2comme dans le cas de la figure 5A.

Si alors une décharge partielle se produit, une perturbation électrique 31 est produite dans le signal haute tension passant dans le câble haute tension 9.

La perturbation électrique génère deux impulsions de perturbation qui se propagent dans le câble haute tension 9 :

- une première impulsion de perturbation qui se propage depuis le site de décharge partielle 30 vers le poste HTA/BT central PC selon la direction 100, et

- une deuxième impulsion de perturbation qui se propage depuis le précurseur de défaut 30 vers le deuxième poste HTA/BT voisin P2 selon la direction 200.

Après avoir parcouru une longueur inférieure à L2, la première impulsion de perturbation atteint le poste HTA/BT central PC.

Au cours de la deuxième étape E2, le système d'acquisition 3 mesure la première impulsion de perturbation à un instant de détection d0. La figure 5B représente la mesure obtenue par le système d'acquisition 3 et l'instant de détection d0.

La première impulsion de perturbation poursuit sa propagation et traverse le poste HTA/BT central PC dans la direction de la flèche 102 vers le premier poste HTA/BT voisin P1.

Après avoir parcouru la longueur L1, la première impulsion de perturbation est réfléchie en partie au niveau 103 du premier poste HTA/BT voisin P1.

Une première impulsion réfléchie qui est la partie réfléchie de la première impulsion de perturbation se propage dans la direction de la flèche 104.

La première impulsion réfléchie parcourt une longueur L1, avant de parvenir au poste HTA/BT central PC.

Toujours au cours de la deuxième étape E2, la première impulsion réfléchie est mesurée par le système d'acquisition 3 à l'instant d1.

La deuxième impulsion de perturbation se propage quant à elle dans la direction de la flèche 200 vers le deuxième poste HTA/BT voisin P2.

Après avoir parcouru une longueur inférieure à la longueur L2, la deuxième impulsion de perturbation est réfléchie en partie au niveau 111 du premier poste HTA/BT voisin P1. Une deuxième impulsion réfléchie qui est la partie réfléchie de la deuxième impulsion de perturbation se propage dans la direction de la flèche 202.

La deuxième impulsion réfléchie parcourt une longueur L2, avant de parvenir au poste HTA/BT central PC.

Toujours au cours de la deuxième étape E2, la deuxième impulsion réfléchie est mesurée par le système d'acquisition 3 à l'instant d2.

Comme dans la situation précédente, le système d'acquisition 3 peut mesurer la valeur instantanée de la tension du signal haute tension aux trois instants de détection d0, d1 et d2.

La figure 5B représente la mesure obtenue par le système d'acquisition 3 et les instants de détection d0, d1 et d2. Selon la position du site de décharge partielle 40 comprise entre le poste HTA/BT central PC et le premier poste HTA/BT voisin P1, l'instant d1 peut être antérieur, égal ou postérieur à l'instant d2.

A l'issue de l'étape E2, le système d'acquisition 3 a acquis un ensemble de trois impulsions qui forment une mesure de la signature de la perturbation électrique due à la décharge partielle. Ces trois impulsions électriques proviennent de la propagation et des réflexions sur les postes HTA/BT voisins P1 et P2 de la perturbation électrique générée par le site de Décharge Partielle. La répartition temporelle des impulsions dépend de la position du site de décharge partielle. L'amplitude des impulsions dépend de l'ampleur de la décharge. La signature est donc caractéristique du site de décharge partielle, et donne des informations sur sa localisation et la gravité de la défaillance dans la conduction électrique due à ce site.

Si une nouvelle perturbation électrique est générée par le site de Décharge Partielle, une nouvelle mesure de la signature est obtenue.

La mesure de la première signature peut être enregistrée dans la mémoire 6.

Il peut être nécessaire de connaître sur laquelle des trois phases du câble haute tension se situe le site de décharge partielle. Cela peut notamment permettre d'augmenter le rapport signal sur bruit et d'améliorer la qualité de la détermination de la localisation du site de décharge partielle.

A cet effet au cours d'une étape E21 le système d'acquisition 3 peut acquérir un ensemble de trois impulsions qui forment une mesure de première signature pour chacune des trois phases. Les trois signatures peuvent être enregistrées dans la mémoire 6.

Puis, au cours d'une étape E22, l'unité de traitement 2 compare les trois premières signatures et identifie la phase détériorée pour laquelle la première signature présente les mesures de plus fortes amplitudes.

Au cours d'une troisième étape E3, l'unité de traitement 2 compare la mesure de la première signature à la première signature de référence.

Dans le cas où la phase détériorée a été identifiée, l'unité de traitement 2 compare la mesure de la première signature de la phase détériorée à la première signature de référence de la phase détériorée.

La signature de référence comprend trois impulsions de référence ou trois pics de référence, que l'on désigne dans l'ordre chronologique premier pic de référence, deuxième pic de référence et troisième pic de référence.

*Comparaison de mesure de la signature de la perturbation et de la signature de référence*

Au cours d'une quatrième étape E4, l'unité de traitement 2 met en coïncidence temporelle le pic initial de la mesure de la première signature et le pic initial de la première signature de référence.

Il est ensuite recherché et enregistré :

- un pic de référence non coïncident qui ne coïncide avec aucun pic de la première signature,
- un pic non coïncident qui est un pic de la première signature ne coïncidant pas temporellement avec aucun pic de référence, et

- une durée utile séparant dans la première signature le premier pic et le pic non coïncident déterminé.

Dans une première possibilité, un pic de la mesure de la première signature coïncide temporellement avec le deuxième pic de référence, et un pic de la première signature ne coïncide pas temporellement avec le troisième pic de référence, c'est le cas des figures 3 et 5B.

Dès lors,

- le pic de référence non coïncident est le troisième pic de référence,
- le premier pic non coïncident est le pic daté d2 sur la figure 5B, et
- la durée utile est notée $\Delta td$ sur la figure 5B.

Dans une deuxième possibilité, un pic de la première signature coïncide temporellement avec le troisième pic de référence, et un pic de la première signature ne coïncide pas temporellement avec le deuxième pic de référence, c'est le cas des figures 3 et 4B.

Dès lors,

- le pic de référence non coïncident est le deuxième pic de référence,
- le premier pic non coïncident est le pic daté g1 sur la figure 4B, et
- la durée utile est notée $\Delta tg$ sur la figure 4B.

Au cours d'une cinquième étape E5, l'unité de traitement 2 détermine la position du site de Décharge Partielle en fonction du premier pic non coïncident et de la durée utile, ainsi que du pic de référence non coïncident.

Si le pic de référence non coïncident est le deuxième pic de référence, le site de décharge partielle se situe entre le poste HTA/BT central PC et le premier poste HTA/BT voisin P1 comme dans le cas de la figure 4A.

La distance Dg séparant le poste HTA/BT central PC et le site de décharge partielle peut être calculée selon la relation suivante :

$$Dg= L1 - 0.5 \times Vp \times \Delta tg$$

Si le pic de référence non coïncident est le troisième pic de référence, le site de décharge partielle se situe entre le poste HTA/BT central PC et le deuxième poste HTA/BT voisin P2 comme dans le cas de la figure 5A.

La distance Dd séparant le poste HTA/BT central PC et le site de décharge partielle peut être calculée selon la relation suivante :

$$Dd= L2 - 0.5 \times Vp \times \Delta td$$

En amont de la mise en oeuvre du procédé de détection, les paramètres suivants sont déterminés et enregistrés dans la mémoire 6 :

- la vitesse de propagation Vp des phénomènes transitoires dans le câble haute tension,
- la longueur L1 de la portion de câble haute tension entre le poste HTA/BT central PC et le premier poste HTA/BT voisin P1, et

La longueur L2 de la portion de câble haute tension entre le poste HTA/BT central PC et le deuxième poste HTA/BT voisin P2.

*Suivi temporel*

Une fois la position de décharge partielle déterminée, et au cours d'une sixième étape (E6) un certain nombre d'informations peut être déterminé puis enregistré ou mis à jour : l'énergie, l'amplitude, la fréquence et/ou de la valeur du signal haute tension d'apparition des mesures de la première signature du site de Décharge Partielle.

Il est possible en effet avec le dispositif de détermination 1 de mesurer pour chaque signature mesurée :

- l'amplitude des trois impulsions formant la signature,
- l'énergie électrique contenue dans les trois impulsions formant la signature, et
- la valeur du signal haute tension à la position du site de décharge partielle et au moment du déclenchement de la décharge partielle.

Ces informations sont enregistrées dans la mémoire 6.

La détection de la première signature d'une perturbation électrique générée par le site de Décharge Partielle est normalement suivie dans le temps par la détection d'autres signatures de perturbations générées par le même site de Décharge Partielle.

Le suivi des signatures des perturbations dues à un site de décharge partielle au cours du temps, permet d'enregistrer les informations d'amplitude et d'énergie de la perturbation électrique ainsi que de la valeur du signal haute tension au moment de la décharge partielle. Par ailleurs, le taux de répétition aussi désigné par fréquence d'activation du site de décharges partielles peut être mesurée et mis à jour au cours du temps.

Il est à noter que le fait de mesurer la valeur instantanée de la tension du signal haute tension dans la phase aux trois instants de détection des impulsions qui forment la première signature, permet de faire une analyse en résolution de phase. Cette analyse couramment employée est dénommée sous l'acronyme anglais PRPD (Phase Résolution Partial Discharges, soit analyse en résolution de phase de décharge partielle).

Connaître la valeur de la tension du signal haute tension au moment où la décharge partielle se produit permet de mieux caractériser le site de décharge partielle.

L'activité d'un site de décharge partielle est en effet conditionnée par la valeur instantanée de la tension de réseau. La décharge partielle ne se produit pas endessous d'un certain écart de la tension à zéro. Cet écart minimum constitue un seuil de déclenchement du site de décharge partielle.

L'analyse en résolution de phase permet de déterminer le seuil de déclenchement et la fréquence d'activation, c'est-à-dire le taux de répétition avec lequel une décharge partielle se produit au site de décharge partielle.

Plus le seuil est bas et plus le taux de répétition est important et plus la défaillance dans la conduction électrique au site de décharge partielle est grave.

Par ailleurs, connaître la valeur de la tension du signal haute tension au moment où la décharge partielle se produit permet également de mieux le séparer du bruit de mesure. La décharge partielle ne se produit pas endessous d'un certain écart de la tension à zéro, alors que les mesures de bruit sont mesurées de manière homogène en fonction de la phase du signal haute tension.

Les trois informations d'amplitude, d'énergie électrique et de valeur du signal haute tension de chaque signature renseignent sur la gravité et l'évolution de la gravité de la défaillance dans la conduction électrique au site de décharge partielle.

Ces informations permettent en effet de connaître l'évolution de l'importance des décharges partielles, la fréquence des décharges partielles et le seuil de déclenchement du site de décharge partielle.

*Cas particulier où la signature ne comprend que deux impulsions*

Il existe des cas où la dernière impulsion de la première signature ne peut pas être distinguée du bruit. C'est le cas notamment lorsque la décharge partielle est de faible amplitude et de faible énergie, ou lorsque le site de décharge partielle se situe loin du système d'acquisition.

Dans ce cas, la première signature ne comprend que deux impulsions ou pics.

Il convient alors de distinguer les deux situations suivantes.

La première situation se produit lorsque le deuxième pic de la première signature ne coïncide temporellement pas avec le deuxième pic de référence.

Dans cette première situation, on note $\Delta tg$ la première durée qui sépare dans la première signature le premier pic et le deuxième pic. Le site de décharge partielle se situe entre le poste HTA/BT central PC et le premier poste HTA/BT voisin P1 comme dans le cas de la figure 4A, et la distance Dg séparant le poste HTA/BT central PC et le site de décharge partielle peut être calculée selon la relation donnée plus haut.

La deuxième situation se produit lorsque le deuxième pic de la première signature coïncide temporellement avec le deuxième pic de référence. Dans cette deuxième situation la détermination de la position d'un site de décharge partielle nécessite d'adapter le procédé de localisation et d'utiliser un deuxième détecteur de détermination.

*Procédé de localisation utilisant deux détecteurs de détermination*

La détermination de la position d'un site de décharge partielle peut être menée en utilisant un premier dispositif de détermination placé dans un premier poste HTA/BT de détection, et un deuxième dispositif de détermination placé dans un deuxième poste HTA/BT de détection.

Ces deux dispositifs de détection sont identiques à ceux décrits plus haut et présentent le même fonctionnement.

Au cours de l'étape E1 (respectivement T1) illustrée sur la figure 2, le premier dispositif de détection peut générer et mesurer une première signature de référence (respectivement une deuxième signature de référence).

Lorsqu'un site de décharge partielle est activé et qu'une décharge partielle se produit entre le premier poste HTA/BT de détection et le deuxième poste HTA/BT de détection, le premier dispositif de détection mesure une première signature de la perturbation électrique générée par la décharge partielle au cours de l'étape E2 éventuellement complétée des sous étapes E21 et E22, le deuxième dispositif de détection mesure une deuxième signature de la perturbation électrique générée par la décharge partielle au cours de l'étape T2 éventuellement complétée des sous étapes T21 et T22.

Au cours de l'étape E3, la première signature est comparée à la première signature de référence.

Au cours de l'étape T3, la deuxième signature est comparée à la deuxième signature de référence.

Au cours de l'étape E4, une première impulsion non coïncidente qui ne coïncide avec aucun pic de référence de la première signature de référence la première signature est comparée à la première signature de référence. Comme décrit précédemment, sont aussi déterminés dans cette étape E4 d'une part une durée utile séparant dans la première signature le premier pic et le pic non coïncident déterminé et d'autre part un premier pic de référence non coïncident qui ne coïncide avec aucun pic de la première signature.

Au cours de l'étape T4, une deuxième impulsion non coïncidente qui ne coïncide avec aucun pic de référence de la deuxième signature de référence la deuxième signature est comparée à la deuxième signature de référence. Comme décrit précédemment, sont aussi déterminés dans cette étape T4 d'une part une durée utile séparant dans la deuxième signature le premier pic et le pic non coïncident déterminé et d'autre part un premier pic de référence non coïncident qui ne coïncide avec aucun pic de la deuxième signature.

Chaque dispositif de détermination produit donc un résultat de position du site de décharge partielle. Ces deux résultats sont normalement identiques, ou donnent du moins des positions écartées d'une distance compatible avec les marges d'erreur de mesure des systèmes d'acquisition.

Au cours de l'étape E5, les deux résultats sont pris en compte pour fournir une position du site de décharge partielle.

Dans le cas précédemment évoqué où la signature mesurée par le premier poste HTA/BT de détection ne comprend que deux impulsions, deux situations peuvent se présenter.

Dans la première situation, le deuxième poste HTA/BT de détection mesure pour la même perturbation électrique une deuxième signature comprenant trois impulsions. Une détermination de la position du site de décharge partielle est alors possible en utilisant cette deuxième signature. La position déterminée de ce site de décharge partielle doit être compatible avec le fait que la première signature ne comprend que deux impulsions. En particulier, il est possible de s'assurer que :

- le site de décharge partielle doit se situer plus près du deuxième poste HTA/BT de détection que du premier poste HTA/BT de détection,
- la distance séparant le site de décharge partielle du premier poste HTA/BT de détection et l'amplitude de la deuxième signature sont cohérents avec une atténuation du troisième pic de la première signature en dessous du seuil de bruit.

Dans la deuxième situation, l'autre poste HTA/BT mesure pour la même perturbation électrique une deuxième signature qui ne comprend que deux impulsions. Dans cette deuxième situation, il est toujours possible de déterminer la position du site de décharge partielle.

En effet, parmi la première signature et la deuxième signature, l'une des deux présente un deuxième pic qui ne coïncide pas temporellement avec son deuxième pic de référence. En suivant les étapes décrites plus haut, la position du site de décharge partielle peut être déterminée.

*Effets techniques et avantages*

Le procédé de localisation d'un site de Décharge Partielle tel qu'on l'a présenté plus haut utilise une technique de type réflectométrie. Un signal électrique initial qui se propage dans le câble haute tension 9 subit à chaque variation d'impédance une réflexion partielle. C'est en particulier le cas dans les postes HTA/BT, où le signal initial subit une réflexion partielle. En disposant un détecteur en un poste HTA/BT central adapté pour détecter un signal initial généré par un site de décharge partielle et ses différentes réflexions sur les postes HTA/BT voisins du poste HTA/BT central, il est possible d'obtenir la répartition temporelle des passages du signal initial et de ses différentes réflexions au poste central HTA/BT.

En particulier, le procédé tel qu'on l'a présenté plus haut utilise des impulsions électriques dues à des réflexions de la perturbation électrique créées au niveau d'au moins deux postes HTA/BT voisins du poste HTA/BT central.

A partir de cette répartition temporelle, il est possible de déterminer la position du site de décharge partielle.

L'ensemble des mesures étant réalisé par un seul détecteur, il n'est pas nécessaire de synchroniser deux capteurs séparés géographiquement.

Aucun dispositif couteux destiné spécifiquement à la synchronisation temporelle n'est donc nécessaire pour mettre en oeuvre le procédé proposé.

Par ailleurs, une fois obtenues la signature de référence et la première signature, le traitement effectué sur ces signatures par l'unité de traitement est suffisamment simple mathématiquement pour être mis en oeuvre dans un ordinateur équipé d'un processeur qu'il est possible d'installer dans le poste central HTA/BT. L'exploitation des mesures peut être menée localement sans qu'un serveur distant soit nécessaire.

Le procédé de localisation d'un site de Décharge Partielle tel qu'on l'a présenté plus haut peut être réalisé « on line » c'est-à-dire lorsque le câble haute tension est « en fonctionnement » : le câble est connecté au reste du réseau de distribution et qu'il est alimenté par le signal haute tension du réseau de distribution.

Le caractère « en fonctionnement » du procédé présente l'avantage de ne pas mobiliser une équipe de techniciens, de ne pas être limité temporellement à la durée de l'intervention de l'équipe et de poursuivre la distribution électrique en utilisant tous les câbles haute tension du système de distribution électrique.

Par exemple, il est possible d'adapter le procédé pour effectuer à intervalles réguliers une mesure de signature de référence, afin de la mettre à jour et de surveiller l'état du câble haute tension 9.

Ces mesures de signature de référence peuvent être complétées par la mesure de la valeur du signal haute tension qui alimente la phase, c'est-à-dire la tension instantanée du signal haute tension qui alimente la phase dans laquelle est mesurée la signature de référence. A partir de ces couples de mesures simultanées d'une signature de référence d'une phase et de la valeur du signal haute tension qui alimente la phase, il est possible de suivre les variations de la signature de référence au cours du temps.

Toute variation d'amplitude de la signature de référence représente un changement d'impédance de la phase.

Cette information régulière sur l'état du câble haute tension 9 permet par exemple de générer un signal d'alerte si la variation d'amplitude détectée est supérieure à un seuil prédéterminé.

Certains types de dégradation peuvent en effet être identifiées et caractérisés par la variation de leur impédance locale en fonction de la tension et en fonction du temps. Par exemple, il est possible d'identifier l'échauffement d'une jonction sous l'effet du courant de charge de la liaison. A froid, c'est-à-dire sous charge faible, l'impédance de la jonction est faible. Le procédé de localisation par réflectométrie ne permet pas de détecter la jonction. A chaud cependant l'impédance de la jonction peut augmenter sensiblement jusqu'à créer une rupture d'impédance visible par réflectométrie.

**Revendications**

1. Procédé (P) de détermination d'une position d'un site de Décharge Partielle au sein d'une phase détériorée d'une ligne haute tension en fonctionnement, la ligne haute tension étant formée d'une pluralité de câbles haute tension reliant une pluralité de postes HTA/BT (P1, P2, PC) entre eux, comprenant les étapes suivantes :

   (E2) acquisition par un premier poste HTA/BT d'une mesure d'une première signature dans le signal haute tension se propageant dans la phase détériorée, la première signature comportant des impulsions électriques dues à une propagation et des réflexions au sein de la phase détériorée d'une perturbation électrique générée par le site de Décharge Partielle,
   (E3) comparaison de la mesure de la première signature à une première signature de référence de la phase détériorée, la première signature de référence ayant été déterminée au préalable au cours d'une calibration par réflectométrie d'un signal de référence injecté au sein du premier poste HTA/BT (PC),
   (E4) identification, lorsque la mesure de la première signature est superposée avec la première signature de référence de sorte qu'une impulsion initiale de la mesure de la première signature et une impulsion initiale de la première signature de référence coïncident, d'une première impulsion non-coïncidente dans la mesure de la première signature qui ne coïncide avec aucune impulsion de la première signature de référence,
   et d'une première impulsion de référence non-coïncidente dans la première signature de référence qui ne coïncide avec aucune impulsion de la mesure de la première signature,
   (E5) détermination de la position du site de Décharge Partielle en fonction de la durée qui sépare l'impulsion initiale et la première impulsion non-coïncidente dans la mesure de la première signature.

2. Procédé selon la revendication 1, dans lequel la première signature comporte des impulsions électriques dues à des réflexions de la perturbation électrique créées au niveau d'au moins deux postes HTA/BT voisins du premier poste HTA/BT.

3. Procédé selon la revendication 1 ou 2, dans lequel différents câbles haute tension sont tous reliés directement au premier poste HTA/BT, chaque câble haute tension comprenant au moins une phase, chaque phase étant alimentée par un signal haute tension respectif, l'étape (E2) d'acquisition par un premier poste HTA/BT d'une mesure d'une première signature comprenant une détermination de la phase détériorée selon les sous étapes suivantes :

   acquisition (E21) par le premier poste HTA/BT de mesures de premières signatures dans les différents signaux alimentant les phases des différents câbles haute tension,
   identification (E22) de la phase détériorée pour laquelle la première signature présente les mesures de plus fortes amplitudes.

4. Procédé selon la revendication 3, comprenant une étape (E6) de détermination de l'énergie, l'amplitude, la fréquence d'apparition et/ou de la valeur du signal haute tension des mesures de la première signature du site de Décharge Partielle.

5. Procédé selon la revendication 3, comprenant les étapes suivantes :

   (T2) acquisition par un deuxième poste HTA/BT d'une mesure d'une deuxième signature dans le signal haute tension se propageant dans la phase détériorée, la mesure de la deuxième signature comportant des impulsions électriques dues à une propagation et des réflexions au sein de la phase détériorée d'une perturbation électrique générée par le site de Décharge Partielle,
   (T3) comparaison de la mesure de la deuxième signature à une deuxième signature de référence de la phase détériorée, la deuxième signature de référence ayant été déterminée au préalable au cours d'une calibration par réflectométrie d'un signal de référence injecté au sein du deuxième poste HTA/BT,
   (T4) identification, lorsque la mesure de la deuxième signature est superposée avec la deuxième signature de référence de sorte qu'une impulsion initiale de la mesure de la deuxième signature et une impulsion initiale de la deuxième signature de référence coïncident, d'une deuxième impulsion non-coïncidente dans la mesure de la deuxième signature qui ne coïncide avec aucune impulsion de la deuxième signature de référence, et d'une deuxième impulsion de référence non-coïncidente dans la deuxième signature de référence qui ne coïncide avec aucune impulsion de la mesure de la deuxième signature,

l'étape (E5) de détermination de la position du site de Décharge Partielle étant réalisée aussi en fonction d'une durée qui sépare l'impulsion initiale et la deuxième impulsion non-coïncidente dans la mesure de la deuxième signature.

6. Procédé selon la revendication 1, dans lequel l'étape (E2) d'acquisition par un premier poste HTA/BT d'une mesure d'une première signature comprend en outre la détection d'une valeur du signal haute tension à chaque instant d'acquisition d'une mesure de la première signature.

7. Procédé selon l'une des revendications 1 à 6, dans lequel pour chaque phase reliée au premier poste HTA/BT, une série de couples de mesures simultanées est réalisée, un couple de mesures simultanées comprenant une mesure à un instant de mesure d'une signature de référence de la phase par le poste HTA/BT et une mesure à l'instant de mesure d'une valeur du signal haute tension qui alimente la phase, une détection d'une variation d'amplitude de la signature de référence en fonction de la valeur du signal haute tension et en fonction de l'instant, la variation d'amplitude étant représentative d'un changement d'impédance de la phase, un signal d'alerte est généré si la variation d'amplitude détectée est supérieure à un seuil prédéterminé.

8. Dispositif de détermination (1) d'une position d'un site de Décharge Partielle au sein d'une phase détériorée d'une ligne haute tension en fonctionnement, la ligne haute tension étant formée d'une pluralité de câbles haute tension reliant une pluralité de postes HTA/BT (P1, P2, PC) entre eux, comprenant :

un système d'acquisition (3) de signaux électriques adapté pour acquérir une mesure sur la phase détériorée d'une première signature d'un site de Décharge Partielle (30, 40),

une unité de traitement (2) adaptée pour comparer la mesure de la première signature à une première signature de référence de la phase détériorée, la première signature de référence ayant été déterminée au préalable au cours d'une calibration par réflectométrie d'un signal de référence injecté au sein d'un poste HTA/BT, identifier, lorsque la mesure de la première signature est superposée avec la première signature de référence de sorte qu'une impulsion initiale de la mesure de la première signature et une impulsion initiale de la première signature de référence coïncident, une première impulsion non-coïncidente dans la mesure de la première signature qui ne coïncide avec aucune impulsion de la première signature de référence, et d'une première impulsion de référence non-coïncidente dans la première signature de référence qui ne coïncide avec aucune impulsion de la mesure de la première signature,

déterminer la position du site de Décharge Partielle (30, 40) en fonction de la durée qui sépare l'impulsion initiale et la première impulsion non-coïncidente dans la mesure de la première signature.

9. Dispositif selon la revendication 8, comprenant en outre un injecteur (4) adapté pour envoyer sur la phase détériorée un signal de référence.

10. Dispositif selon la revendication 8 ou 9, dans lequel la première signature comporte des impulsions électriques dues à des réflexions de la perturbation électrique créées au niveau d'au moins deux postes HTA/BT (P1, P2) voisins d'un premier poste HTA/BT (PC).

11. Dispositif selon l'une des revendications 9 à 10, dans lequel le système d'acquisition (3) de signaux électriques est adapté en outre pour acquérir sur des phases de différents câbles haute tension reliés directement à un poste HTA/BT des mesures d'une première signature d'un site de Décharge Partielle, et l'unité de traitement (2) est adaptée en outre pour identifier la phase détériorée pour laquelle la première signature présente les mesures de plus fortes amplitudes.

12. Dispositif selon l'une des revendications 9 à 11, dans lequel le système d'acquisition (3) et l'unité de traitement (2) sont adaptés pour déterminer l'énergie, l'amplitude, la fréquence et/ou de la valeur du signal haute tension d'apparition des mesures de la première signature du site de Décharge Partielle (30,40).

13. Ensemble de deux dispositifs selon l'une des revendications 8 à 12, un premier dispositif des deux dispositifs étant destiné à être placé dans un premier poste HTA/BT, et un deuxième dispositif des deux dispositifs étant destiné à être placé dans un deuxième poste HTA/BT différent du premier poste HTA/BT.

**Patentansprüche**

1. Verfahren (P) zum Bestimmen einer Position einer Teilentladungsstelle innerhalb einer beschädigten Phase einer Hochspannungsleitung im Betrieb, wobei die Hochspannungsleitung aus einer Vielzahl von Hochspannungskabeln gebildet wird, die eine Vielzahl von HS/NS-Stationen (P1, P2, PC) miteinander verbinden, umfassend den folgenden Schritten:

(E2) Erfassen einer Messung einer ersten Signatur im Hochspannungssignal, das sich in der beschädigten Phase ausbreitet, durch eine erste HS/NS-Station, wobei die erste Signatur elektrische Impulse umfasst, die auf eine Ausbreitung und Reflexionen innerhalb der beschädigten Phase einer elektrischen Störung zurückzuführen sind, die durch die Teilentladungsstelle erzeugt wurde,

(E3) Vergleichen der Messung der ersten Signatur mit einer ersten Referenzsignatur der beschädigten Phase, wobei die erste Referenzsignatur zuvor im Laufe einer Kalibrierung durch Reflektometrie eines Referenzsignals bestimmt wurde, das innerhalb der ersten HS/NS-Station (PC) eingespeist wurde,

(E4) Identifizieren, wenn die Messung der ersten Signatur mit der ersten Referenzsignatur derart überlagert wird, dass ein Anfangsimpuls der Messung der ersten Signatur und ein Anfangsimpuls der ersten Referenzsignatur übereinstimmen, eines ersten nicht übereinstimmenden Impulses in die Messung der ersten Signatur, die mit keinem Impuls der ersten Referenzsignatur übereinstimmt, und eines ersten nicht übereinstimmenden Referenzimpulses in der ersten Referenzsignatur, der mit keinem Impuls der Messung der ersten Signatur übereinstimmt,

(E5) Bestimmen der Position der Teilentladungsstelle in Abhängigkeit von der Dauer, die den Anfangsimpuls und den ersten nicht übereinstimmenden Impuls bei der Messung der ersten Signatur trennt.

2. Verfahren nach Anspruch 1, bei dem die erste Signatur elektrische Impulse aufgrund von Reflexionen der elektrischen Störung umfasst, die an mindestens zwei HS/NS-Stationen erzeugt werden, die an die erste HS/NS-Station angrenzen.

3. Verfahren nach Anspruch 1 oder 2, bei dem verschiedene Hochspannungskabel alle direkt mit der ersten HS/NS-Station verbunden sind, wobei jedes Hochspannungskabel mindestens eine Phase umfasst, wobei jede Phase von einem jeweiligen Hochspannungssignal versorgt wird, wobei der Schritt (E2) des Erfassens einer Messung einer ersten Signatur durch eine erste HS/NS-Station ein Bestimmen der beschädigten Phase gemäß den folgenden Unterschritten umfasst:

Erfassen (E21) von Messungen der ersten Signaturen in den verschiedenen Signalen, die die Phasen der verschiedenen Hochspannungskabel versorgen, durch die erste HS/NS-Station, Identifizieren (E22) der beschädigten Phase, für die die erste Signatur die Messungen mit den höchsten Amplituden aufweist.

4. Verfahren nach Anspruch 3, umfassend einen Schritt (E6) des Bestimmens der Energie, der Amplitude, der Häufigkeit des Auftretens und/oder des Werts des Hochspannungssignals der Messungen der ersten Signatur der Teilentladungsstelle.

5. Verfahren nach Anspruch 3, umfassend die folgenden Schritte:

(T2) Erfassen einer Messung einer zweiten Signatur im Hochspannungssignal, das sich in der beschädigten Phase ausbreitet, durch eine zweite HS/NS-Station, wobei die Messung der zweiten Signatur elektrische Impulse umfasst, die auf eine Ausbreitung und Reflexionen innerhalb der beschädigten Phase einer elektrischen Störung zurückzuführen sind, die durch die Teilentladungsstelle erzeugt wurde,

(T3) Vergleichen der Messung der zweiten Signatur mit einer zweiten Referenzsignatur der beschädigten Phase, wobei die zweite Referenzsignatur zuvor im Laufe einer Kalibrierung durch Reflektometrie eines Referenzsignals bestimmt wurde, das innerhalb der zweiten HS/NS-Station eingespeist wurde,

(T4) Identifizieren, wenn die Messung der zweiten Signatur mit der zweiten Referenzsignatur derart überlagert wird, dass ein Anfangsimpuls der Messung der zweiten Signatur und ein Anfangsimpuls der zweiten Referenzsignatur übereinstimmen, eines nicht übereinstimmenden zweiten Impulses bei der Messung der zweiten Signatur, der mit keinem Impuls der zweiten Referenzsignatur übereinstimmt, und eines nicht übereinstimmenden zweiten Referenzimpulses in der zweiten Referenzsignatur, der mit keinem Impuls der Messung der zweiten Signatur übereinstimmt,

wobei der Schritt (E5) des Bestimmens der Position der Teilentladungsstelle auch in Abhängigkeit von einer Zeitdauer durchgeführt wird, die den Anfangsimpuls und den zweiten nicht übereinstimmenden Impuls bei der Messung der zweiten Signatur trennt.

6. Verfahren nach Anspruch 1, bei dem der Schritt (E2) des Erfassens einer Messung einer ersten Signatur durch eine erste HS/NS-Station ferner das Erfassen eines Werts des Hochspannungssignals zu jedem Zeitpunkt des Erfassens einer Messung der ersten Signatur umfasst.

**7.** Verfahren nach einem der Ansprüche 1 bis 6, bei dem für jede mit der ersten HS/NS-Station verbundene Phase eine Reihe von Paaren gleichzeitiger Messungen durchgeführt wird, wobei ein Paar gleichzeitiger Messungen eine Messung zu einem Messzeitpunkt einer Referenzsignatur der Phase durch die HS/NS-Station und eine Messung zu dem Messzeitpunkt eines Werts des Hochspannungssignals, das die Phase versorgt, eine Detektion einer Amplitudenvariation der Referenzsignatur in Abhängigkeit von dem Wert des Hochspannungssignals und in Abhängigkeit von dem Zeitpunkt umfasst, wobei die Amplitudenvariation für eine Impedanzänderung der Phase repräsentativ ist, wobei ein Warnsignal erzeugt wird, wenn die detektierte Amplitudenvariation größer als ein vorbestimmter Schwellenwert ist.

**8.** Vorrichtung zum Bestimmen (1) einer Position einer Teilentladungsstelle innerhalb einer beschädigten Phase einer Hochspannungsleitung im Betrieb, wobei die Hochspannungsleitung aus einer Vielzahl von Hochspannungskabeln gebildet wird, die eine Vielzahl von HS/NS-Stationen (P1, P2, PC) miteinander verbinden, umfassend:

ein Erfassungssystem (3) für elektrische Signale, das dazu ausgelegt ist, eine Messung an der beschädigten Phase einer ersten Signatur einer Teilentladungsstelle (30, 40) zu erfassen, eine Verarbeitungseinheit (2), die dazu ausgelegt ist,
die Messung der ersten Signatur mit einer ersten Referenzsignatur der beschädigten Phase zu vergleichen, wobei die erste Referenzsignatur zuvor im Laufe einer Kalibrierung durch Reflektometrie eines Referenzsignals bestimmt wurde, das innerhalb einer HS/NS-Station eingespeist wurde,
wenn die Messung der ersten Signatur mit der ersten Referenzsignatur derart überlagert wird, dass ein Anfangsimpuls der Messung der ersten Signatur und ein Anfangsimpuls der ersten Referenzsignatur übereinstimmen, einen ersten nicht übereinstimmenden Impuls bei der Messung der ersten Signatur, der nicht mit einem Impuls der ersten Referenzsignatur übereinstimmt, und einen ersten nicht übereinstimmenden Referenzimpuls in der ersten Referenzsignatur, der nicht mit einem Impuls der Messung der ersten Signatur übereinstimmt, zu identifizieren,
die Position der Teilentladungsstelle (30, 40) in Abhängigkeit von der Zeitdauer zu bestimmen, die den Anfangsimpuls und den ersten nicht übereinstimmenden Impuls bei der Messung der ersten Signatur trennt.

**9.** Vorrichtung nach Anspruch 8, ferner umfassend einen Injektor (4), der dazu ausgelegt ist, ein Referenzsignal an die beschädigte Phase zu senden.

**10.** Vorrichtung nach Anspruch 8 oder 9, bei der die erste Signatur elektrische Impulse aufgrund von Reflexionen der elektrischen Störung umfasst, die an mindestens zwei HS/NS-Stationen (P1, P2) erzeugt werden, die an eine erste HS/NS-Station (PC) angrenzen.

**11.** Vorrichtung nach einem der Ansprüche 9 bis 10, bei der das Erfassungssystem (3) für elektrische Signale ferner dazu ausgelegt ist, an den Phasen verschiedener Hochspannungskabel, die direkt mit einer HS/NS-Station verbunden sind, Messungen einer ersten Signatur einer Teilentladungsstelle zu erfassen, und die Verarbeitungseinheit (2) ferner dazu ausgelegt ist, die beschädigte Phase zu identifizieren, für die die erste Signatur die Messungen mit den höchsten Amplituden aufweist.

**12.** Vorrichtung nach einem der Ansprüche 9 bis 11, bei der das Erfassungssystem (3) und die Verarbeitungseinheit (2) dazu ausgelegt sind, die Energie, die Amplitude, die Frequenz und/oder den Wert des Hochspannungssignals des Auftretens der Messungen der ersten Signatur der Teilentladungsstelle (30, 40) zu bestimmen.

**13.** Anordnung aus zwei Vorrichtungen nach einem der Ansprüche 8 bis 12, wobei eine erste Vorrichtung der beiden Vorrichtungen dazu bestimmt ist, in einer ersten HS/NS-Station platziert zu werden, und eine zweite Vorrichtung der beiden Vorrichtung dazu bestimmt ist, in einer zweiten HS/NS-Station platziert zu werden, die sich von der ersten HS/NS-Station unterscheidet.

**Claims**

**1.** A method (P) for determining a position of a partial discharge site within a deteriorated phase of a high-voltage line in operation, the high-voltage line being formed by a plurality of high-voltage cables connecting a plurality of HV/LV substations (P1, P2, PC) to one another, comprising the following steps:

(E2) acquisition by a first HV/LV substation of a measurement of a first signature in the high-voltage signal propagating in the damaged phase, the first signature comprising electrical pulses due to propagation and reflections within the damaged phase of an electrical disturbance generated by the partial discharge site,

(E3) comparison of the measurement of the first signature with a first reference signature of the damaged phase, the first reference signature having been determined beforehand during calibration by reflectometry of a reference signal injected into the first MV/LV substation (PC),

(E4) identification, when the measurement of the first signature is superimposed with the first reference signature so that an initial pulse of the measurement of the first signature and an initial pulse of the first reference signature coincide, of a first non-coincident pulse in the measurement of the first signature which does not coincide with any pulse of the first reference signature, and of a first non-coincident reference pulse in the first reference signature which does not coincide with any pulse of the measurement of the first signature,

(E5) determination of the position of the partial discharge site as a function of the time between the initial pulse and the first non-coincident pulse in the first signature measurement.

2. Method according to claim 1, wherein the first signature comprises electrical pulses due to reflections of the electrical disturbance created at at least two MV/LV substations adjacent to the first MV/LV substation.

3. Method according to claim 1 or 2, in which different high-voltage cables are all connected directly to the first MV/LV substation, each high-voltage cable comprising at least one phase, each phase being supplied with a respective high-voltage signal, the step (E2) of acquisition by a first MV/LV substation of a measurement of a first signature comprising a determination of the damaged phase according to the following sub-steps :

   acquisition (E21) by the first MV/LV substation of measurements of first signatures in the various signals feeding the phases of the various high-voltage cables,
   identification (E22) of the damaged phase for which the first signature has the highest amplitude measurements.

4. Method according to claim 3, comprising a step (E6) for determining the energy, amplitude, frequency of appearance and/or value of the high-voltage signal of the measurements of the first signature of the partial discharge site.

5. Method according to claim 3, comprising the following steps:

   (T2) acquisition by a second MV/LV substation of a measurement of a second signature in the high-voltage signal propagating in the damaged phase, the measurement of the second signature including electrical pulses due to propagation and reflections within the damaged phase of an electrical disturbance generated by the partial discharge site,

   (T3) comparison of the measurement of the second signature with a second reference signature of the damaged phase, the second reference signature having been determined beforehand during calibration by reflectometry of a reference signal injected into the second MV/LV substation,

   (T4) identification, when the second signature measurement is superimposed with the second reference signature so that an initial pulse of the second signature measurement and an initial pulse of the second reference signature coincide, of a non-coincident second pulse in the second signature measurement which does not coincide with any pulse of the second reference signature, and of a non-coincident second reference pulse in the second reference signature which does not coincide with any pulse of the second signature measurement,

   the step (E5) of determining the position of the partial discharge site also being carried out as a function of a duration which separates the initial pulse and the second non-coincident pulse in the second signature measurement.

6. Method according to claim 1, in which the step (E2) of acquisition by a first MV/LV substation of a measurement of a first signature further comprises detection of a value of the high-voltage signal at each instant of acquisition of a measurement of the first signature.

7. Method according to one of claims 1 to 6, in which for each phase connected to the first MV/LV substation, a series of pairs of simultaneous measurements is carried out, a pair of simultaneous measurements comprising a measurement at a measurement instant of a reference signature of the phase by the MV/LV substation and a measurement at the measurement instant of a value of the high-voltage signal supplying the phase, detection of a variation in amplitude of the reference signature as a function of the value of the high-voltage signal and as a function of the instant, the variation in amplitude being representative of a change in impedance of the phase, an alert signal is generated if the variation in amplitude detected is greater than a predetermined threshold.

8. A device (1) for determining the position of a partial discharge site within a damaged phase of a high-voltage line in operation, the high-voltage line being formed by a plurality of high-voltage cables interconnecting a plurality of HV/LV substations (P1, P2, PC), comprising :

an electrical signal acquisition system (3) adapted to acquire a measurement on the deteriorated phase of a first signature of a partial discharge site (30, 40),

a processing unit (2) adapted to

compare the measurement of the first signature with a first reference signature of the deteriorated phase, the first reference signature having been previously determined during calibration by reflectometry of a reference signal injected into a MV/LV substation,

identify, when the measurement of the first signature is superimposed with the first reference signature so that an initial pulse of the measurement of the first signature and an initial pulse of the first reference signature coincide, a first non-coincident pulse in the measurement of the first signature which does not coincide with any pulse of the first reference signature, and a first non-coincident reference pulse in the first reference signature which does not coincide with any pulse of the measurement of the first signature,

determine the position of the partial discharge site (30, 40) as a function of the time between the initial pulse and the first non-coincident pulse in the first signature measurement.

9. Device according to claim 8, further comprising an injector (4) adapted to send a reference signal to the deteriorated phase.

10. Device according to claim 8 or 9, wherein the first signature comprises electrical pulses due to reflections of the electrical disturbance created at at least two MV/LV substations (P1, P2) adjacent to a first MV/LV substation (PC).

11. Device according to one of claims 9 to 10, wherein the electrical signal acquisition system (3) is further adapted to acquire on phases of different high-voltage cables connected directly to a HTA/BT substation measurements of a first signature of a partial discharge site, and the processing unit (2) is further adapted to identify the deteriorated phase for which the first signature exhibits the highest amplitude measurements.

12. Device according to one of claims 9 to 11, wherein the acquisition system (3) and the processing unit (2) are adapted to determine the energy, amplitude, frequency and/or value of the high-voltage signal of occurrence of the measurements of the first signature of the partial discharge site (30,40).

13. A set of two devices according to one of claims 8 to 12, a first one of the two devices being intended to be placed in a first HV/LV substation, and a second one of the two devices being intended to be placed in a second HV/LV substation different from the first HV/LV substation.

# Figure 1

# Figure 2

acquisition d'une première signature de référence — E1

acquisition d'une première signature — E2

acquisition de mesures de la première signature dans les différentes phases des différents câbles haute-tension — E21

identification de la phase détériorée — E22

comparaison de la première signature à la première signature de référence — E3

identification d'une première impulsion qui ne coïncide temporellement avec aucune impulsion de référence comprise dans la première signature de référence — E4

détermination de la position du site de Décharge Partielle — E5

détermination des énergie amplitude fréquence valeur du signal haute-tension des mesures de la première signature du site de Décharge Partielle — E6

acquisition d'une deuxième signature de référence — T1

acquisition d'une deuxième signature — T2

acquisition de mesures de la deuxième signature dans les différentes phases des différents câbles haute-tension — T21

identification de la phase détériorée — T22

comparaison de la deuxième signature à la deuxième signature de référence — T3

identification d'une deuxième impulsion qui ne coïncide temporellement avec aucune impulsion de référence comprise dans la deuxième signature de référence — T4

P

## Figure 3

## Figure 4A

## Figure 4B

## Figure 5A

## Figure 5B

**EP 3 798 649 B1**

## RÉFÉRENCES CITÉES DANS LA DESCRIPTION

**Documents brevets cités dans la description**

- FR 3003410 A1